# EUROPEAN PATENT APPLICATION

(11) **EP 1 662 023 A1**
(43) Date of publication of application: **31.05.2006**
(21) Application number: 04748001.7
(22) Date of filing: 21.07.2004
(51) Int. Cl.: C25B 11/12, C23C 16/27, C30B 29/04

(54) **METHOD OF COATING FOR DIAMOND ELECTRODE**

(30) Priority: 07.08.2003 JP 2003319016
(71) Applicant: EBARA CORPORATION, Tokyo 144-8510 (JP)
(72) Inventor: Fujimura, Hiroyuki, Ebara Corporation, Ohta-ku, Tokyo 144-8510 (JP); Ito, Kanichi, Ebara Corporation, Ohta-ku, Tokyo 144-8510 (JP)
(74) Representative: Wagner, Karl H.
(86) International application number: PCT/JP2004/010689
(87) International publication number: WO 2005/014886

(57) **Abstract**

The present invention relates to a film-formation method of a diamond electrode used in an electrolytic processing apparatus and other devices for treating water and waste liquid. This method utilizes CVD such as hot filament CVD including supplying a high-concentration carbon source to form a low-quality thick first diamond film (1) on a substrate at a high rate, and then supplying a low-concentration carbon source to form a high-quality thin second diamond film (2) on the first film at a low rate. This structure can prevent oxidation corrosion due to OH radical and can prevent entry of an electrolytic solution into the film, thereby enhancing durability of the diamond film. The thick first diamond film is formed at a high rate, and the second diamond film is made thin at a low rate. Therefore, a total film-formation time can be short, and a low-cost diamond electrode can be made.

## Description

### Technical Field

The present invention relates to a method of forming a film of a diamond electrode used in an electrolytic processing apparatus and other devices for treating water, waste liquid, and the like.

### Background Art

A diamond electrode, which is covered with a boron-doped diamond film, is known to decompose certain substances which would not be decomposed by conventional electrodes, and to exhibit strong bactericidal effects. This is because the diamond electrode has a wide electrical chemical potential and produces an OH radical having high oxidation activity. Accordingly, application of the diamond electrode is expected in various fields including water treatment and waste liquid treatment. However, at present, the diamond electrode has problems which prevent its practical application. For example, a formation rate of the diamond film is very low, and the diamond electrode is more expensive than noble metal. In addition, the diamond film has low durability. Specifically, the OH radical produced on the diamond electrode may decompose and consume the diamond film, and may cause removal of the diamond film. If the formation rate is lowered, or a thickness of the diamond film is increased in order to enhance durability of the diamond film, a long film-formation time is required, thus increasing a production cost. There is a trade-off between durability and cost cutting.

Japanese laid-open patent publication No. 11-157990 discloses "a method of forming a diamond single-crystal thin film" as a method of forming a diamond thin film at a high rate using microwave plasma CVD. This method was made based on experimental results showing that a low formation rate of a diamond film (a first layer) contacting a substrate results in a small amount of impurities in a second layer formed on the first layer even if a formation rate of the second layer is about twice that of the first layer. Specifically, the first layer, i.e., a high-quality thin film, is formed at a low formation rate with a concentration of methane, serving as a carbon source, being not more than 0.3 %. Subsequently, the second layer is formed on the first layer at a high formation rate with a higher methane concentration than that when forming the first layer. However, this method cannot achieve a short film-formation time because, in order to prevent a decrease in quality of the second layer (i.e., surface side layer of the diamond film), the methane concentration is required to be not more than 0.5 %, and as a result, an actual formation rate falls to 0.3 µm/h at most.

### Disclosure of Invention

The present invention has been made in view of the above drawbacks. It is, therefore, an object of the present invention to provide a diamond electrode used in an electrolytic processing apparatus and other devices which can enhance durability of a diamond film and can achieve a high-formation rate and a reduced production cost.

Upon solving the above drawbacks, the inventors noticed from the above-mentioned document and experimental results the following phenomena:
(1) In hot filament CVD, plasma CVD, and other CVD film-formation processes, if high-concentration methane is supplied in order to increase a film-formation rate, impurities, such as graphite, amorphous carbon, or substrate carbide, and crystal defects increase in a diamond film. As a result, color of the film becomes black, not transparent.
(2) Under a normal temperature, diamond has a high corrosion resistance. However, the above impurities existing in the film are easily oxidized by an OH radical produced on an anode. This oxidization of the impurities results in consumption and removal of the diamond film.
(3) A high-quality diamond film generally has a function to repair defects on a surface of a low-quality diamond film. The high-quality film, which has substantially no impurities, can be formed on the low-quality film having defects by lowering the formation rate of the diamond film. This high-quality film can prevent oxidation corrosion due to the OH radical and can prevent entry of an electrolytic solution into the film, thus enhancing durability of the diamond film. Forming the high-quality film up to at most 1µm does not require a long period of time even if the film-formation rate is low, and therefore, a reduced cost can be achieved.
(4) When a diamond film contacting a substrate is formed at a high rate, amorphous carbon increases therein. However, amorphous carbon serves to enhance adhesion to the substrate. So long as thickness is within several tens µm, a thicker diamond film can more effectively disperse forces applied thereto, thus enhancing film strength. Accordingly, it is preferable that the thickness of the diamond film contacting the substrate is not less than 5 µm. Forming the diamond film at a high rate can shorten a film-formation time even if the film is thick, and therefore, a reduced cost can be achieved.
(5) Examples of known materials used to form a substrate include Si, Mo, W, Fe, Ni, Co, and graphite. Particularly, Si is widely used as a substrate of a diamond electrode because it has a low coefficient of thermal expansion and exhibits good adhesion to a diamond film. On the other hand, graphite has a high coefficient of thermal expansion, but is advantageous in terms of low cost. Further, when an amount of graphite contained in the diamond film contacting the substrate increases, adhesion to the substrate is improved because the substrate is made of the same material. In this case, an average coefficient of thermal expansion of the film approaches a coefficient of thermal expansion of the substrate, and therefore, thermal stress due to a difference in thermal expansion is reduced.

Based on the above characteristic phenomena, in order to solve the drawbacks, the present invention recited in claim 1 provides a method of forming a film of a diamond electrode. This method comprises performing a CVD process by supplying a mixed gas comprising a carbon source and hydrogen to form a diamond film on a substrate. Performing the CVD process comprises forming, as an outermost surface of the diamond film, a high-quality diamond film having substantially no impurities.

According to the present invention recited in claim 2, the CVD process comprises a first process of supplying the mixed gas containing a high-concentration carbon source to form a low-quality thick first diamond film on the substrate at a high film-formation rate, and a second process of supplying the mixed gas containing a low-concentration carbon source to form a high-quality thin second diamond film on the first diamond film at a low film-formation rate.

According to the present invention recited in claim 3, the CVD process comprises one of a hot filament CVD process and a microwave plasma CVD process, methane is used as the carbon source, a concentration of the methane used in the first process is in a range of 1 to 10 %, and a concentration of the methane used in the second process is not more than 1 %, preferably not more than 0.3 %.

According to the present invention recited in claim 4, the first diamond film is formed so as to have a thickness of not less than 1 µm, preferably not less than 10 µm, and the second diamond film is formed so as to have a thickness of not more than 1 µm.

According to the present invention recited in claim 5, graphite is used as material of the substrate.

The present invention has the following advantageous effects:
According to the present invention, a high-quality thin second diamond film is formed at a low rate so as to constitute a surface of a diamond electrode. Therefore, this thin film can prevent oxidation corrosion due to an OH radical, and can prevent entry of an electrolytic solution into the film, thus enhancing durability of the diamond electrode. Although a formation rate of the second diamond film is low, this film is thin, and accordingly, a reduced cost can be achieved.

A first diamond film contacting a substrate is formed at a high rate, and hence, it contains large amounts of graphite and amorphous carbon. However, because the first diamond film is made thick, forces applied thereto can be dispersed, and hence film strength can be enhanced. Although the first diamond film is made thick, a film-formation rate is high. Accordingly, a reduced cost can be achieved.

Use of graphite as material of the substrate can reduce a cost of the substrate. In addition, because graphite contained in the first diamond film contacting the substrate is the same material as the substrate, adhesion of the film to the substrate can be improved. Further, because an average coefficient of heat expansion of the film approaches a coefficient of heat expansion of the substrate, thermal stress due to a difference in heat expansion can be reduced.

### Brief Description of Drawings

FIGS. 1A and 1B are views illustrating principles of the present invention, with FIG. 1A being a schematic view showing an enlarged cross section of a diamond film of the present invention, and FIG. 1B being a schematic view illustrating a methane concentration during formation of the diamond film; and
FIG. 2 is a view illustrating a hot filament CVD apparatus.

### Best Mode for Carrying Out the Invention

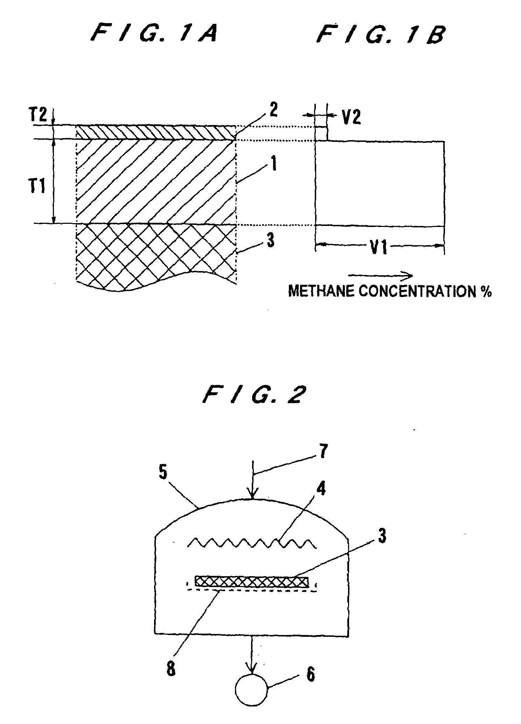

FIG. 1A and FIG. 1B are views illustrating principles of the present invention. Specifically, FIG. 1A is a schematic view showing an enlarged cross section of a diamond layer of the present invention, and FIG. 1B is a schematic view illustrating a methane concentration during formation of the diamond layer. FIG. 2 is a view illustrating a hot filament CVD apparatus.

As illustrated in FIG. 2 showing the hot filament CVD apparatus, a substrate 3 is placed in a CVD decompression chamber 5. A seed crystal of fine diamond particles is rubbed in advance onto a surface of the substrate 3. The CVD decompression chamber 5 is evacuated by a vacuum pump 6 so that a raw gas 7 flows into the chamber 5 under a reduced pressure of between 1330 and 13300 Pa (between 10 and 100 Torr). An electric furnace (not illustrated) is provided outside the chamber 5 so as to keep a temperature of the substrate 3 in the range of 700 to 1000 °C. In the drawing, a reference numeral 8 represents a substrate holder. The raw gas 7 is a mixed gas comprising a hydrogen gas, a carbon source, and a slight amount of a boron source serving as a dopant. Typically, methane is used as the carbon source, and diborane is used as the boron source. A hot filament 4, which is heated to between 2000 and 2200 °C, is disposed above the substrate. The raw gas 7 is heated by the hot filament 4, and is thus converted into highly reactive products, which diffuse to reach the substrate 3 where a diamond film doped with boron is formed thereon and grows.

In this process, a concentration of methane in the raw gas 7 is an important factor which affects a formation rate of the diamond film on the substrate 3, an amount of impurities, such as graphite, amorphous carbon, and substrate carbide in the diamond film, and an amount of crystal defects. Specifically, high-concentration methane results in a high film-formation rate, but results in increase in impurities and defects. On the other hand, low-concentration methane results in decrease in impurities and defects, but results in a low film-formation rate. When the concentration of methane in the raw gas is in the range of 0.3 to 5 %, the formation rate of the diamond film falls in the range of 1 to 5 µm/h. In order to form a high-quality diamond film, the concentration of methane is required to be not more than 1 %, preferably about 0.3 %.

As shown in FIGS. 1A and 1B, in this method, a first process is performed so as to supply raw gas 7 containing high-concentration methane, whose concentration V1 is in the range of 1 to 10 %, so that a first diamond film 1 having a thickness T1 of not less than 5 µm is formed directly on the substrate 3. Subsequently, a second process is performed so as to supply raw gas 7 containing low-concentration methane, whose concentration V2 is about 0.3 % (< 1 %), so that a second diamond film 2 having a thickness T2 of not more than 1 µm is formed on the first diamond film 1. In the first process, when the methane concentration V1 is 5 %, a corresponding film-formation rate is about 5 µm/h. Therefore, a period of time required for forming the first diamond film 1 until its thickness T1 exceeds 5 µm is a little over 1 hour. In the second process, when the methane concentration V2 is about 0.3 %, a corresponding film-formation rate is about 1 µm/h. Therefore, a period of time required for forming the second diamond film 2 having the thickness T2 of not more than 1 µm is less than 1 hour. Accordingly, a total time required is on the order of 2 hours. This means that a high-quality diamond electrode can be obtained in a practical production time.

According to the above film-formation method, the thin, but high-quality and dense second diamond film 2 constituting the surface of the diamond electrode can prevent oxidation corrosion due to an OH radical, and can prevent entry of an electrolytic solution into the film, thus enhancing durability of the diamond film. Furthermore, because the first diamond film 1 is made thick although it contains large amounts of graphite and amorphous carbon, forces applied thereto can be dispersed, and hence film strength can be enhanced. In addition, an adhesive effect of carbon can enhance adhesion of the diamond film to the substrate 3.

Si, which has a low coefficient of heat expansion and has good adhesiveness to a substrate, is often used as material of the substrate. However, in this method, low-cost graphite is used for the following reasons. The first diamond film 1 contacting the substrate 3 contains a large amount of graphite. Therefore, use of graphite as material of the substrate 3 can improve adhesion of the diamond film because the first diamond film 1 containes the same material impurities, i.e., graphite. Further, use of graphite can reduce adverse effects due to a difference in heat expansion because an average coefficient of heat expansion of the film approaches a coefficient of heat expansion of the substrate.

### Industrial Applicability

The method according to the present invention can provide a long-life low-cost diamond electrode which is useful for various applications including an electrolytic processing apparatus for treating water and a waste liquid containing refractory substances, and a sensor for sensing a slight amount of substance in an aqueous solution, in addition to conventional applications including a bactericidal process for treating drinking water and pool water.

## Claims

1. A method of forming a film of a diamond electrode, said method comprising:
performing a CVD process by supplying a mixed gas comprising a carbon source and hydrogen to form a diamond film on a substrate,
wherein performing said CVD process comprises forming, as an outermost surface of the diamond film, a high-quality diamond film having substantially no impurities.

2. The method according to claim 1, wherein said CVD process comprises:
a first process of supplying the mixed gas containing a high-concentration carbon source to form a low-quality thick first diamond film on the substrate at a high film-formation rate; and
a second process of supplying the mixed gas containing a low-concentration carbon source to form a high-quality thin second diamond film on the first diamond film at a low film-formation rate.

3. The method according to claim 2, wherein:
said CVD process comprises one of a hot filament CVD process and a microwave plasma CVD process;
methane is used as the carbon source;
a concentration of the methane used in said first process is in a range of 1 to 10 %; and
a concentration of the methane used in said second process is not more than 1 %, preferably not more than 0.3 %.

4. The method according to claim 2, wherein:
the first diamond film is formed so as to have a thickness of not less than 1 µm, preferably not less than 10 µm; and
the second diamond film is formed so as to have a thickness of not more than 1 µm.

5. The method according to claim 2, wherein graphite is used as material of the substrate.
